# EUROPÄISCHE PATENTSCHRIFT

(11) **EP 1 825 520 B1**
(45) Veröffentlichungstag und Bekanntmachung des Hinweises auf die Patenterteilung: **11.12.2019**
(21) Anmeldenummer: 05796933.9
(22) Anmeldetag: 13.10.2005
(51) Int. Cl.: H01L 29/66, H01L 29/872, H01L 29/861, H01L 21/329, H01L 29/866

(54) **HALBLEITEREINRICHTUNG UND VERFAHREN ZU DEREN HERSTELLUNG**
SEMICONDUCTOR DEVICE AND METHOD FOR PRODUCTION THEREOF
DISPOSITIF A SEMI-CONDUCTEUR ET PROCEDE DE FABRICATION

(30) Priorität: 10.12.2004 DE 102004059640
(43) Veröffentlichungstag der Anmeldung: 29.08.2007
(73) Patentinhaber: ROBERT BOSCH GMBH, 70442 Stuttgart (DE)
(72) Erfinder: GOERLACH, Alfred, 72127 Kusterdingen (DE); QU, Ning, 72770 Reutlingen (DE)
(86) Internationale Anmeldenummer: PCT/EP2005/055227
(87) Internationale Veröffentlichungsnummer: WO 2006/061277

(56) Entgegenhaltungen:
- EP-A- 1 139 433
- US-A- 4 982 260
- US-A- 5 262 668
- US-A- 6 078 090
- US-A1- 2002 008 237
- US-B1- 6 362 495
- US-B1- 6 562 706

## Beschreibung

### Stand der Technik

Die Erfindung betrifft eine Halbleitereinrichtung nach dem Oberbegriff des Anspruchs 1 sowie ein Verfahren zu deren Herstellung. Bei der Halbleitereinrichtung der gattungsgemäßen Art handelt es sich dabei um eine Trench-Schottky-Barrier-Schottky-Diode.

In modernen Kraftfahrzeugen werden immer mehr Funktionen mit elektrischen Bauelementen realisiert. Dadurch entsteht ein immer höherer Bedarf an elektrischer Leistung. Um diesen Bedarf zu decken muss die Effizienz des Generatorsystems in Kfz gesteigert werden.

Bis heute werden in der Regel PN-Dioden als Z-Dioden im Kfz-Generatorsystem als Gleichrichter eingesetzt. Vorteile der PN-Dioden sind niedriger Sperrstrom und hohe Robustheit. Der Hauptnachteil von PN-Dioden ist die hohe Flussspannung *UF.* Bei Raumtemperatur beginnt Strom erst bei *UF*=0.7V zu fließen. Und unter normaler Betriebsbedingung, z. B. Stromdichte von 500A/cm², steigt *UF* bis über 1V an, was einen unvernachlässigbaren Verlust der Effizienz bedeutet.

Theoretisch steht die Schottky-Diode als Alternative zur Verfügung. Schottky-Dioden haben eine deutlich niedrigere Flussspannung als PN-Dioden, beispielsweise 0.5V bis 0.6V bei einer hohen Stromdichte von 500A/cm². Außerdem bieten Schottky-Dioden als Majoritätsträgerbauelemente Vorteile bei schnellem Schaltbetrieb. Der Einsatz von Schottky-Dioden in Kfz-Generatorsystem erfolgt jedoch bis heute nicht. Dies ist auf einige entscheidende Nachteile von Schottky-Dioden zurückzuführen: 1) höherer Sperrstrom im Vergleich zu PN-Dioden, 2) starke Abhängigkeit des Sperrstroms von der Sperrspannung und 3) schlechte Robustheit, insbesondere bei Hochtemperatur.

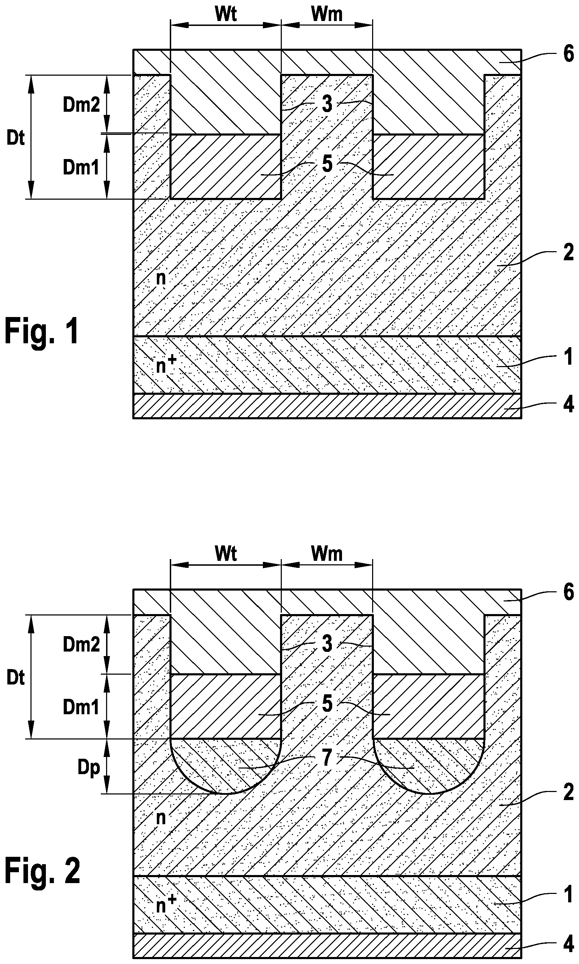

Herkömmliche Schottky-Dioden können in ihren elektrischen Eigenschaften verändert werden, indem durch Ätzen realisierte Gräben (Trenches) eingebracht werden. Solche weiterentwickelte Schottky-Dioden werden auch als Trench-Schottky-Barrier-Schottky-Diode (TSBS) bezeichnet. Ein Beispiel für eine derartige bekannte Halbleitereinrichtung ist in Figur 1 dargestellt.

Die bekannten Trench-Schottky-Barrier-Schottky-Dioden weisen jedoch nicht die nötige Robustheit auf, die sie benötigen, um als Z-Dioden für den Einsatz in Kraftfahrzeuggeneratorsystemen verwendet zu werden.

Aus der US 6,562,706 B1 und der US 6,426,541 B2 sind bereits Halbleiterelemente mit Schottky-Kontakten in einem Graben bekannt. Keine dieser Schriften offenbart die Verwendung einer PN-Diode im Graben, mit einer Durchbruchsspannung, die geringer ist, als die Durchbruchspannung der Schottky-Kontakte.

### Vorteile der Erfindung

Die erfindungsgemäßen Halbleitereinrichtungen mit den Merkmalen des Anspruchs 1 haben dagegen den Vorteil hoher Robustheit und sind daher geeignet, als Z-Dioden in Kraftfahrzeug-Generatorsystemen eingesetzt zu werden.

Erzielt werden diese Vorteile, indem eine Trench-Schottky-Barrier-Schottky-Diode (TSBS-Diode) mit einer integrierten PN-Diode als Klammerelement versehen wird. Dabei werden die zusätzlichen p-Wannen so dimensioniert, dass die Durchbruchspannung der PN-Diode niedriger ist als die Durchbruchspannung der Schottky-Diode.

Weitere Vorteile der Erfindung werden durch die in den Unteransprüchen angegebenen Maßnahmen erzielt.

Durch Ausgestaltung der Trench-Schottky-Barrier-Schottky-Diode (TSBS-Diode) mit integrierter PN-Diode als Klammerelement (TSBS-PN) ist es in besonders vorteilhafter Weise möglich, die Diode als Z-Diode zu betreiben. Bei einer Durchbruchspannung der Z-Diode von ca. 20 Volt ist diese für den Einsatz in Kfz-Generatorsystemen geeignet und kann als Gleichrichterelement für den Gleichrichter des Generators eingesetzt werden.

Die Herstellung der erfindungsgemäßen Halbleitereinrichtungen nach Variante 1 oder Variante 2 erfolgt mittels geeigneter Verfahren, die an die unterschiedlichen Varianten angepasst sind.

### Zeichnung

Figur 1 zeigt eine bekannte Trench-Schottky-Barrier-Schottky-Diode (TSBS),
Figur 2 zeigt ein erstes Ausführungsbeispiel der Erfindung mit einer Trench-Schottky-Barrier-Schottky-Diode mit integrierter PN-Diode als Klammerelement (TSBS-PN) nach Anspruch 1 und
Figur 3 zeigt ein weiteres Ausführungsbeispiel der Erfindung mit einer Trench-Schottky-Barrier-Schottky-Diode mit integrierter PN-Diode als Klammerelement (TSBS-PN) mit Barriere-Oxid nach Anspruch 1.

### Beschreibung

Wie Figur 1 zeigt, besteht die Trench-Schottky-Barrier-Schottky-Diode (TSBS) aus einem n⁺-Substrat 1, einer n dotierten Epischicht 2, mindestens zwei in der n-Epischicht 2 durch Ätzen realisierten Gräben (Trenchs) 3 der Tiefe *Dt,* und einer Metallschicht 4 an der Rückseite des Chips als ohmscher Kontakt bzw. Kathodenelektrode. Die beiden Gräben 3 werden zuerst mit einem Metall 5 einer Dicke *Dm1* ausgefüllt und anschließend mit einem zweiten Metall 6 bedeckt. Das zweite Metall 6 füllt die Reste der Gräben mit einer Dicke *Dm2* aus. Die beiden Metalle 5 und 6 an der Vorderseite des Chips dienen als Schottky-Kontakte bzw. Anodenelektrode.

Das zweite Metall 6 hat in der Regel eine kleinere Barrierenhöhe als das erste Metall 5. Elektrisch gesehen ist daher die TSBS eine Kombination von zwei Schottky-Dioden mit unterschiedlichen Barrierenhöhen: eine Schottky-Diode mit Schottky-Barriere zwischen dem Metall 5 als Anode und der n-Epischicht 2 als Kathode und eine zweite Schottky-Diode mit Schottky-Barriere zwischen dem Metall 6 als Anode und der n-Epischicht 2 als Kathode.

In Flussrichtung, zumindest wenn die Barrierenhöhen der beiden Metalle deutlich unterschiedlich sind, fließen Ströme hauptsächlich zum oberen Metall 6 mit der niedrigeren Barriere, auch an den entsprechenden Seitenwänden der Gräben. Sofern gilt *Dm2 > Wt* ist die effektive Fläche für den Stromfluss in der Flussrichtung bei einer TSBS größer im Vergleich zu einer konventionellen Planar-Schottky-Diode.

In Sperrrichtung sorgt das erste Metall 5 mit seiner größeren Barrierenhöhe für große Ausdehnung der Raumladungszonen. Die Raumladungszonen dehnen sich mit steigender Spannung aus und stoßen bei einer Spannung, die kleiner als die Durchbruchspannung der TSBS ist, in der Mitte des Bereichs zwischen den benachbarten Gräben 3 zusammen. Dadurch werden die für hohe Sperrströme verantwortlichen Schottky-Effekte abgeschirmt und die Sperrströme reduziert. Dieser Abschirmeffekt ist stark von Strukturparametern *Dt,* (der Tiefe des Grabens), *Wm,* (Abstand zwischen den Gräben), *Wt* (Breite des Grabens) sowie von *Dm1* (Dicke des ersten Metalls 5) abhängig, siehe Figur 1. Die Ausdehnung der Raumladungszonen im Mesa-Bereich zwischen den Gräben 3 ist quasi-eindimensional, sofern *Dt* deutlich größer als *Wm* ist.

Die Besonderheit einer TSBS ist die Kombination der beiden Metalle, die eine gewisse Trennung der Konstruktionen bzgl. Anforderungen von Flussspannung und Abschirmverhalten ermöglicht. Die Flussspannung *UF* und der Anfangswert des Sperrstroms *IR0* werden vorwiegend vom zweiten Metall 6 mit niedrigerer Barriere beeinflusst. Je größer der Anteil vom zweiten Metall 6, desto niedriger *UF* und desto höher *IR0.* Andererseits bestimmt das erste Metall 5 mit größerer Barriere die Spannungsabhängigkeit des Sperrstroms, die Durchbruchspannung und die Stromverteilung bei hohen Sperrströmen. Die TSBS bietet daher eine Optimierungsmöglichkeit durch Kombination der beiden Metalle. Sowohl die Dicken *Dm1* und *Dm2* als auch die Barrierenhöhen der beiden Metalle können als Parameter eingesetzt werden.

Ein gewisser Nachteil der TSBS liegt jedoch in der Schwäche des Schottky-Kontakts am Grabenboden, da dort beim Durchbruch hohe elektrische Felder und folglich auch hohe Sperrstromdichten entstehen. Aufgrund der Inhomogenität der Grenzschicht am Grabenboden empfiehlt es sich nicht, TSBS als Z-Dioden einzusetzen und im Durchbruchsbereich zu betreiben (Driften, Q-Risiko).

Hergestellt werden solche TSBS-Elemente wie folgt: Realisierung der Gräben 3 durch Ätzen der n-Epischicht 2, Ausfüllen der Gräben 3 mit dem ersten Metall 5, ggf.

Zurückätzen des ersten Metalls auf eine definierte Dicke, und Ausfüllen der Reste der Gräben mit dem zweiten Metall 6.

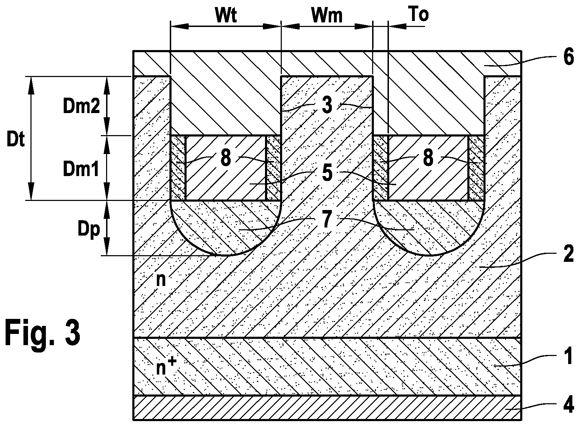

Zwei Varianten von Ausführungsbeispielen der Erfindung sind in den Figuren 2 und 3 dargestellt.

Variante 1: Eine Trench-Schottky-Barrier-Schottky-Diode mit integrierter PN-Diode als Klammerelement (TSBS-PN) mit Polysilizium im unteren Bereich der Gräben ist in Figur 2 dargestellt..

Wie gezeigt, besteht die TSBS-PN des ersten Ausführungsbeispiels der Erfindung aus einem n⁺-Substrat 1, einer n-Epischicht 2, mindestens zwei in die n-Epischicht 2 eingeätzten Gräben (Trenchs) 3 der Tiefe *Dt* und einer Metallschicht 4 an der Rückseite des Chips als ohmscher Kontakt bzw. Kathodenelektrode. Der untere Bereich 7 der Gräben 3 wird mit Poly-Si bis zu einer Höhe *Dp* ausgefüllt. Die Gräben werden dann mit einem Metall 5 einer Dicke *Dm1* ausgefüllt, mit ohmschem Kontakt zum Poly-Si 7 und mit Schottky-Kontakt zur n-Epischicht 2 (Anodenelektrode) und anschließend mit einem zweiten Metall 6 bedeckt. Das zweite Metall 6 füllt die Reste der Gräben mit einer Dicke *Dm2* aus, mit Schottky-Kontakt zur n-Epischicht 2 und dient ebenfalls als Anodenelektrode. Elektrisch gesehen ist die TSBS-PN eine Kombination von zwei Schottky-Dioden mit unterschiedlichen Barrierenhöhen und einer PN-Diode mit den p-Wannen 7 als Anode und der n-Epischicht 2 als Kathode.

Bei der TSBS-PN fließen die Ströme in Flussrichtung nur durch die obere Schottky-Diode. Die untere Schottky-Diode und die PN-Diode stehen nicht zur Verfügung. Die Schottky-Kontakte an den Seitenwänden der Gräben sorgen für eine größere effektive Fläche für die Stromflüsse in Flussrichtung im Vergleich zu konventionellen Planar-Schottky-Dioden, sofern *2Dm2* > *Wt* gilt. In Sperrrichtung bilden sich sowohl bei den Schottky-Barrieren als auch bei dem PN-Übergang Raumladungszonen aus. Die Raumladungszonen dehnen sich mit steigender Spannung aus und stoßen bei einer Spannung, die kleiner als die Durchbruchspannung der TSBS-PN ist, in der Mitte des Bereichs zwischen den benachbarten Gräben 3 zusammen. Dadurch werden die für hohe Sperrströme verantwortlichen Schottky-Effekte abgeschirmt und die Sperrströme reduziert. Dieser Abschirmeffekt ist stark von Strukturparametern *Wm* (Abstand zwischen den Gräben), *Wt* (Breite des Grabens bzw. der p-Wannen), *Dp* (Tiefe des Graben-Anteils mit p-dotiertem Si oder Poly-Si; entspricht Dicke der p-Wannen), sowie *Dm1* (Dicke des ersten Metalls 5) abhängig, siehe Abb. 2.

Die TSBS-PN verfügt über ähnliche Abschirmwirkung von Schottky-Effekten wie die TSBS, bietet aber zusätzlich hohe Robustheit durch die integrierte Klammerfunktion der PN-Diode. Die Durchbruchspannung der PN-Diode *BV_pn* wird so ausgelegt, dass *BV_pn* niedriger als die Durchbruchspannung der Schottky-Dioden *BV_schottky* ist. Der Durchbruch findet am Grabenboden statt und die Durchbruchspannung von TSBS-PN wird durch *BV_pn* bestimmt. Es existiert daher keine hohe Feldstärke in der Nähe der Schottky-Kontakte und die Sperrströme im Durchbruchsbetrieb fließen dann nur durch den PN-Übergang und nicht durch die Schottky-Kontakte wie bei einer konventionellen TSBS. TSBS-PN verfügt damit über die Robustheit einer PN-Diode. Folgendessen ist die TSBS-PN als Z-Diode gut geeignet.

Herstellungsverfahren von TSBS-PN, Variante 1
Schritt 1: einkristallines n⁺-Substrat dient als Ausgangsmaterial.
Schritt 2: in einem Epitaxieverfahren wird die ebenfalls einkristalline n-dotierte Schicht 2 aufgebracht.
Schritt 3: Mittels Grabenätzen werden die Gräben 3 in die Schicht 2 geätzt.
Schritt 4: Es erfolgt ein Ausfüllen der Gräben 3 mit Poly-Si.
Schritt 5: Gegebenenfalls teilweises Ätzen eines Teils des p-dotierten Poly-Si in den Gräben 3.
Schritt 6: Ausfüllen der Gräben 3 mit dem ersten Metall 5.
Schritt 7: ggf. Ätzen des ersten Metalls 5 auf eine definierte Dicke.
Schritt 8: Ausfüllen der Reste der Gräben 3 mit dem zweiten Metall 6.
Schritt 9: Metallisierung auf Rückseite, also Aufbringen der Metallschicht 4 auf der Rückseite des Chips.

Figur 3 zeigt ein weiteres erfindungsgemäßes Ausführungsbeispiel gemäß Variante 2: mit einer Trench-Schottky-Barrier-Schottky-Diode mit integrierter PN-Diode als Klammerelement (TSBS-PN) mit Barriere-Oxid und Polysilizium im unteren Bereich der Gräben (TSBS-BOPN).

Wie Figur 3 zeigt, besteht der Unterschied zur Variante 1 darin, dass bei der Variante 2 eine Oxidschicht 8 zwischen dem ersten Metall 5 und den Seitenwänden der Gräben 3 eingeführt wird. Damit wird eine zusätzliche Barriere-Oxid-Struktur (Trench-MOS-Struktur) realisiert. Diese Variante bekommt daher auch den Name TSBS-BOPN. Zu den wichtigen Strukturparametern gehört nun auch die Oxiddicke *To.*

Das zweite Metall 6 mit niedrigerer Barriere, wie bei der Variante 1, sorgt für die kleinere Flussspannung. Der pn-Übergang am Grabenboden bestimmt die Durchbruchspannung und dient als Klammerelement.

Vorteil der Variante 2 gegenüber der Variante 1 sind einerseits eine bessere Abschirmwirkung und deshalb ein niedrigerer Sperrstrom. Dieser Vorteil ist durch die Trench-MOS-Struktur bedingt, die nun den unteren Schottky-Kontakt ersetzt. Dieser Effekt wird mit zunehmender Barrierenhöhe des Metalls 5 noch etwas verstärkt.

Zwar enthält die Variante 2 eine MOS-Struktur, aber innerhalb der empfindlichen Oxide und im benachbarten Si-Gebiet tritt keine hohe Feldstärke auf. Deshalb braucht man bei einer TSBS-BOPN die Injektion von "heißen" Ladungsträgern nicht zu befürchten. Folgendessen verfügt TSBS-BOPN über Robustheit wie eine PN-Diode und ist für den Betrieb als Z-Diode gut geeignet.

Herstellungsverfahren von TSBS-PN (TSBS-BOPN), Variante 2:
Schritt 1: einkristallines n⁺-Substrat dient als Ausgangsmaterial.
Schritt2: in einem Epitaxieverfahen wird die n-dotierte Schicht 2 aufgebracht.
Schritt 3: Mittels Grabenätzen werden die Gräben 3 geätzt.
Schritt 4: Ausfüllen der Gräben 3 mit Poly-Si.
Schritt 4: Ätzen eines Teils des Poly-Si in den Gräben 3.
Schritt 5: Oxidation der Oberfläche von den Gräben 3.
Schritt 6: Ätzen der Oxide an Boden und Seitenwänden der Gräben 3 auf eine definierte Höhe.
Schritt 7: Ausfüllen der Gräben 3 mit dem ersten Metall 5.
Schritt 8: ggf. Ätzen des ersten Metalls auf eine definierte Dicke.
Schritt 9: Ausfüllen der Reste der Gräben 3 mit dem zweiten Metall.
Schritt 10: Metallisierung auf der Rückseite des Chips.

Sowohl die Variante 1 als auch die Variante 2 können im Randbereich des Chips noch zusätzliche Strukturen zur Reduktion der Randfeldstärke aufweisen. Dies können z. B. niedrig dotierte p-Bereiche, Feldplatten oder ähnliche dem Stand der Technik entsprechende Strukturen sein.

## Patentansprüche

1. Halbleiteranordnung mit einer Trench-Schottky-Barrier-Schottky-Diode mit integrierter PN-Diode als Klammerelement, die eine Kombination von einer Schottky-Diode mit einer niedrigeren Barrierenhöhe, einer Schottky-Diode mit einer höheren Barrierenhöhe und einer PN-Diode umfasst, wobei sich eine n-Silizium-Epischicht (2) auf einem n⁺-Substrat (1) befindet und als Kathodenzone dient, und sich in zweidimensionaler Darstellung mindestens zwei eingeätzte Gräben (3) in der n-Epischicht (2) befinden und deren untere Bereiche (7) mit p-dotiertem Poly-Silizium ausgefüllt sind und als Anodenzone der PN-Diode dienen, wobei gilt, dass die Tiefe Dt der Gräben (3) größer ist als die Breite Wm der sich zwischen den Gräben (3) befindenden Siliziumbereiche, dass ein erstes Metall (5) mit der höheren Barrierenhöhe die Gräben (3) bis zu einer definierten Höhe ausfüllt, mit Ohmschem Kontakt zum p-dotierten Poly-Silizium (7) und mit Schottky-Kontakt zur n-Epischicht (2) und als Anodenelektrode dient, und ein zweites Metall (6) mit der niedrigeren Barrierenhöhe die Reste der Gräben (3) ausfüllt, mit Schottky-Kontakt zur n-Epischicht (2) und ebenfalls als Anodenelektrode dient, und dass die Durchbruchspannung der PN-Diode niedriger als die Durchbruchspannung der Schottky-Dioden ist.

2. Halbleiteranordnung nach Anspruch 1, **dadurch gekennzeichnet, dass** sie eine Zenerdiode bzw. eine Z-Diode mit einer Durchbruchspannung von ca. 20 Volt bildet.

3. Halbleiteranordnung nach Anspruch 2, **dadurch gekennzeichnet, dass** die Zenerdiode bzw. Z-Diode mit hohen Strömen im Durchbruch betreibbar ist.

4. Halbleiteranordnung nach Anspruch 1, **dadurch gekennzeichnet, dass** sich eine Metallschicht (4) auf der Rückseite der Halbleiteranordnung befindet und als Kathodenelektrode dient.

5. Halbleiteranordnung nach einem der vorgehenden Ansprüche, **dadurch gekennzeichnet, dass** die Gräben (3) durch Ätzen in die n-Epischicht (2) hergestellt sind und über eine rechteckige Form oder eine U-Form verfügen.

6. Halbleiteranordnung nach Ansprüchen 1 bis 4, **dadurch gekennzeichnet, dass** die Gräben (3) in Streifenanordnung oder als Inseln angeordnet sind. Die Inseln können kreisförmig, sechseckig oder sonst wie gestaltet sein.

7. Halbleiteranordnung nach einem der vorhergehenden Ansprüche, **dadurch gekennzeichnet, dass** sie als Bestandteil eines Gleichrichters für einen Generator in einem Fahrzeug eingesetzt wird und insbesondere als Z-Diode betrieben wird.

8. Verfahren zur Herstellung einer Halbleitereinrichtung nach einem der vorhergehenden Ansprüche, **dadurch gekennzeichnet, dass** auf ein n-Substrat mittels Epitaxie eine erste Schicht (2) aufgebracht wird, dass in diese erste Schicht (2) Gräben (3) geätzt werden, dass die Gräben (3) ausgefüllt werden mit p-dotiertem Polysilizium, dass ein Teil des p-dotierten Polysiliziums in den Gräben (3) geätzt wird, dass die Gräben (3) mit einem ersten Metall ausgefüllt werden und vorzugsweise das erste Metall geätzt wird auf eine definierte Dicke, dass die Reste der Gräben mit einem zweiten Metall ausgefüllt werden und dass die Rückseite des Substrats mit einer Metallisierung versehen wird.

9. Verfahren zur Herstellung einer Halbleitereinrichtung nach Anspruch 8, **dadurch gekennzeichnet, dass** zusätzlich die Schritte: Oxidation der Oberfläche von Gräben (3) und Ätzen der Oxide an Boden und Seitenwänden der Gräben (3) auf eine definierte Höhe vorgenommen werden.

## Claims

1. Semiconductor arrangement comprising a trench Schottky barrier Schottky diode with integrated PN diode as clamp element, which comprises a combination of a Schottky diode having a lower barrier height, a Schottky diode having a higher barrier height and a PN diode, wherein an n-type silicon epitaxial layer (2) is situated on an n⁺-type substrate (1) and serves as cathode zone, and in a two-dimensional representation at least two etched-in trenches (3) are situated in the n-type epitaxial layer (2) and the lower regions (7) thereof are filled with p-doped polysilicon and serve as anode zone of the PN diode, wherein it holds true that the depth Dt of the trenches (3) is greater than the width Wm of the silicon regions situated between the trenches (3), that a first metal (5) having the higher barrier height fills the trenches (3) up to a defined height, with ohmic contact with the p-doped polysilicon (7) and with Schottky contact with the n-type epitaxial layer (2), and serves as anode electrode, and a second metal (6) having the lower barrier height fills the remainders of the trenches (3), with Schottky contact with the n-type epitaxial layer (2), and likewise serves as anode electrode, and that the breakdown voltage of the PN diode is lower than the breakdown voltage of the Schottky diodes.

2. Semiconductor arrangement according to Claim 1, **characterized in that** it forms a Zener diode or a Z diode having a breakdown voltage of approximately 20 volts.

3. Semiconductor arrangement according to Claim 2, **characterized in that** the Zener diode or Z diode is operable with high currents at breakdown.

4. Semiconductor arrangement according to Claim 1, **characterized in that** a metal layer (4) is situated on the rear side of the semiconductor arrangement and serves as cathode electrode.

5. Semiconductor arrangement according to any of the preceding claims, **characterized in that** the trenches (3) are produced by etching into the n-type epitaxial layer and have a rectangular shape or a U-shape.

6. Semiconductor arrangement according to Claims 1 to 4, **characterized in that** the trenches (3) are arranged in strip arrangement or as islands. The islands can be circular, hexagonal or shaped in any other way.

7. Semiconductor arrangement according to any of the preceding claims, **characterized in that** it is used as part of a rectifier for a generator in a vehicle and is operated in particular as a Z diode.

8. Method for producing a semiconductor device according to any of the preceding claims, **characterized in that** a first layer (2) is applied to an n-type substrate by means of epitaxy **in that** trenches (3) are etched into said first layer (2), **in that** the trenches (3) are filled with p-doped polysilicon, **in that** part of the p-doped polysilicon in the trenches (3) is etched, **in that** the trenches (3) are filled with a first metal and preferably the first metal is etched to a defined thickness, **in that** the remainders of the trenches are filled with a second metal, and **in that** the rear side of the substrate is provided with a metallization.

9. Method for producing a semiconductor device according to Claim 8, **characterized in that** the following steps are additionally performed: oxidation of the surface of trenches (3) and etching of the oxides at the bottom and sidewalls of the trenches (3) to a defined height.

## Revendications

1. Dispositif à semi-conducteur comprenant une diode Schottky à barrière de Schottky à tranchées avec diode PN intégrée comme élément de blocage, comprenant une combinaison d'une diode Schottky présentant une hauteur de barrière inférieure, une diode Schottky présentant une hauteur de barrière supérieure et une diode PN, dans lequel une couche épitaxiale de n-silicium (2) est située sur un substrat n⁺ (1) et sert de zone cathodique, et dans une représentation bidimensionnelle, au moins deux tranchées gravées (3) sont situées dans la couche épitaxiale n (2) et leurs zones inférieures (7) sont remplies de polysilicium dopé p et servent de zone anodique de la diode PN, sous réserve que la profondeur Dt des tranchées (3) est supérieure à la largeur Wm des zones de silicium situées entre les tranchées (3), qu'un premier métal (5) présentant la hauteur de barrière supérieure remplisse les tranchées (3) jusqu'à une hauteur définie, avec un contact ohmique avec le polysilicium dopé p (7) et un contact Schottky avec la couche épitaxiale n (2) et sert d'électrode anodique, et qu'un second métal (6) présentant la hauteur de barrière inférieure remplisse le reste des tranchées (3), avec un contact Schottky avec la couche épitaxiale n (2) et serve également d'électrode anodique, et que la tension de claquage de la diode PN soit inférieure à la tension de claquage des diodes Schottky.

2. Dispositif à semi-conducteur selon la revendication 1, **caractérisé en ce qu'**il forme une diode Zener ou une diode Z présentant une tension de claquage d'environ 20 volts.

3. Dispositif à semi-conducteur selon la revendication 2, **caractérisé en ce que** la diode Zener ou la diode Z peut fonctionner avec des courants élevés au claquage.

4. Dispositif à semi-conducteur selon la revendication 1, **caractérisé en ce qu'**une couche métallique (4) est située sur la face arrière du dispositif à semi-conducteur et sert d'électrode cathodique.

5. Dispositif à semi-conducteur selon l'une des revendications précédentes, **caractérisé en ce que** les tranchées (3) sont formées par gravure dans la couche épitaxiale n (2) et ont une forme rectangulaire ou une forme en U.

6. Dispositif à semi-conducteur selon les revendications 1 à 4, **caractérisé en ce que** les tranchées (3) sont disposées en bandes ou en îlots, les îlots pouvant être circulaires, hexagonaux ou de toute autre forme.

7. Dispositif à semi-conducteur selon l'une des revendications précédentes, **caractérisé en ce qu'**il est utilisé comme composant d'un redresseur destiné à un générateur dans un véhicule et est en particulier utilisé comme diode Z.

8. Procédé de fabrication d'un dispositif à semi-conducteur selon l'une des revendications précédentes, **caractérisé en ce qu'**une première couche (2) est appliquée par épitaxie sur un substrat n, **en ce que** des tranchées (3) sont gravées dans ladite première couche (2), **en ce que** les tranchées (3) sont remplies de polysilicium dopé p, **en ce qu'**une partie du polysilicium dopé p est gravée dans les tranchées (3), **en ce que** les tranchées (3) sont remplies d'un premier métal, le premier métal étant de préférence gravé à une épaisseur définie, **en ce que** le reste des tranchées est rempli d'un second métal et **en ce que** la face arrière du substrat est pourvue d'une métallisation.

9. Procédé de fabrication d'un dispositif à semi-conducteur selon la revendication 8, **caractérisé en ce qu'**il comprend en outre les étapes consistant à : effectuer une oxydation de la surface des tranchées (3) et une gravure des oxydes sur le fond et les parois latérales des tranchées (3) à une hauteur définie.
